Europäisches Patentamt

European Patent Office

Office européen des brevets

(19)

(11) **EP 0 420 182 B1**

(12) **EUROPEAN PATENT SPECIFICATION**

(45) Date of publication and mention
of the grant of the patent:
**03.07.1996 Bulletin 1996/27**

(51) Int Cl.6: **G11C 16/04**, G11C 11/34

(21) Application number: **90118464.8**

(22) Date of filing: **26.09.1990**

(54) **Nonvolatile memory cell and its manufacturing method**

Nichtflüchtige Speicherzelle und ihr Herstellungsverfahren

Cellule de mémoire non volatile et sa méthode de fabrication

(84) Designated Contracting States:
**DE FR**

(30) Priority: **27.09.1989 JP 249311/89**

(43) Date of publication of application:
**03.04.1991 Bulletin 1991/14**

(73) Proprietor: **KABUSHIKI KAISHA TOSHIBA**
**Kawasaki-shi, Kanagawa-ken 210 (JP)**

(72) Inventors:
 • **Hazama, Hiroaki**
 **Yokohama-shi, Kanagawa-ken (JP)**
 • **Nishinohara, Kazumi**
 **Ohta-ku Tokyo (JP)**

(74) Representative: **Lehn, Werner, Dipl.-Ing. et al**
**Hoffmann, Eitle & Partner,**
**Patentanwälte,**
**Postfach 81 04 20**
**81904 München (DE)**

(56) References cited:
 DE-A- 2 151 508          FR-A- 2 437 046
 US-A- 3 878 549          US-A- 3 992 701
 US-A- 4 037 243

 • **PATENT ABSTRACTS OF JAPAN, vol. 8, no. 261**
 **(E-281), 30th November 1984; JP-A- 59 132 679**
 **(FUJITSU KK) 30-06-1984**

## Description

BACKGROUND OF THE INVENTION

1. Field of the Invention

The present invention relates to a nonvolatile memory cell that is capable of being electrically written, read and erased depending on carriers captured by or released from carrier traps formed in a gate insulation film of the memory cell. It also relates to a method of manufacturing the nonvolatile memory cell.

2. Description of the Prior Art

A known nonvolatile memory device capable of being electrically written, read and erased is an EEPROM.

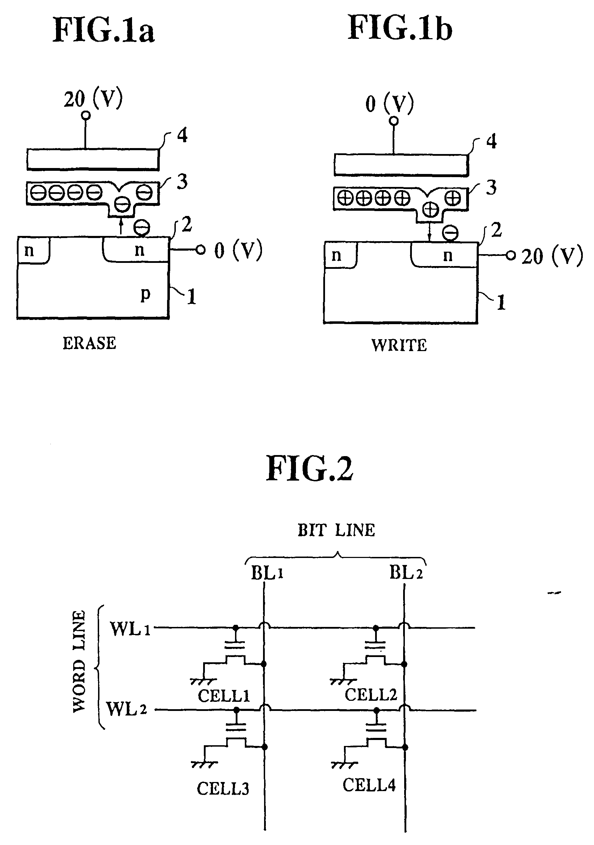

Figures 1a and 1b show a memory cell comprising a transistor having a floating gate, of the EEPROM. To erase the contents of the memory cell in Fig. 1a, a bias voltage of about, for example, 20 V is applied to a control gate 4 and a bias voltage of about 0 V to a drain region 2 formed on a semiconductor substrate 1, thereby injecting electrons from the drain region 2 into a floating gate 3.

To write the memory cell in Fig. 1b, a bias voltage of about 0 V is applied to the control gate 4 and a bias voltage of about 20 V to the drain region 2, thereby releasing electrons from the floating gate 3 toward the drain region 2.

Figure 2 shows a memory device comprising a matrixed array of memory cells each including only the above-mentioned transistor.

To write a cell 1 in Fig. 2, a bias voltage of about 0 V is applied to a word line WL1 and a bias voltage of about 20 V to a bit line BL1, thereby establishing a write state of the cell 1.

Due to the bias voltage of about 20 V on the bit line BL1, a cell 3 will be written if a bias voltage of about 0 V is applied to a word line WL2. To avoid this, a bias voltage of about 20 V is applied to the word line WL2. Also, due to the bias voltage of about 0 V on the word line WL1, a cell 2 will be written if a bias voltage of about 20 V is applied to a bit line BL2. To avoid this, a bias voltage of about 0 V is applied to the bit line BL2.

With the word line WL1 being provided with 0 V, word line WL2 with 20 V, bit line BL1 with 20 V and bit line BL2 with 0 V, a cell 4 receives the bias voltage of about 0 V through its drain region and the bias voltage of about 20 V through its control gate, as shown in Fig. 1a. As a result, the cell 4 will be erased to lose information stored therein.

In this way, if each memory cell includes only the transistor of Fig. 1, the memory cells may interact with one another. It is then impossible to select only one of the memory cells to write or erase the one.

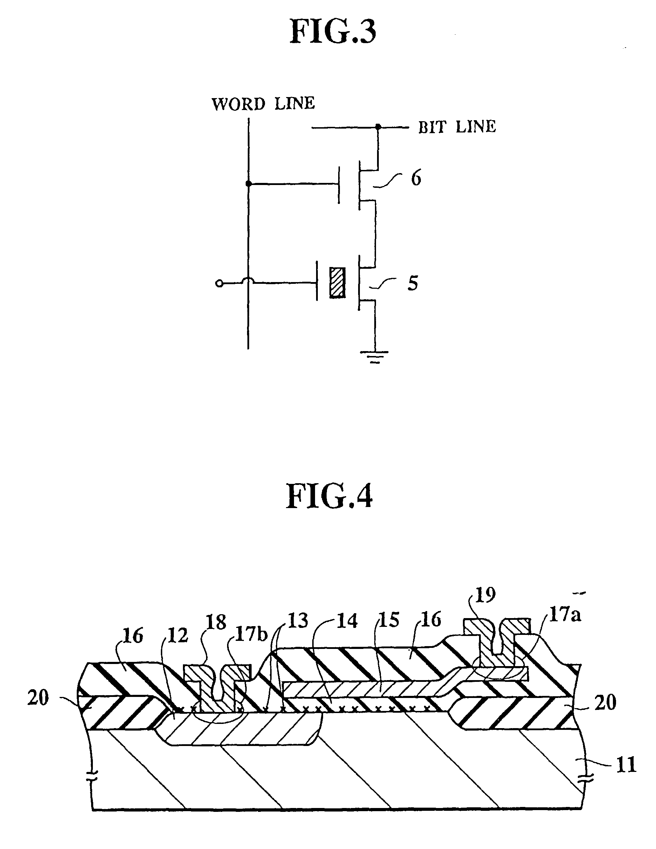

To prevent such interactions of memory cells, "Proc of the 4th on Solid State Devices, Tokyo, 1972" (p. 158) by Iizuka et al. discloses a structure of Fig. 3. According to this, each memory cell comprises a transistor 6 with a floating gate, and a transfer transistor 5. The transistors 5 and 6 are connected in series between a bit line and a ground. By controlling the transfer transistors 5, it is possible to select only one memory cell to write or erase the one.

The structure of Fig. 3, however, needs two transistors for each memory cell.

As explained above, the electrically writable and erasable nonvolatile memory cells each composed of a single transistor having a floating gate interact with one another, so that it is impossible to select and write or erase each of the cells.

On the other hand, the arrangement with the transfer transistors requires two elements for each memory cell, thereby increasing an area of each cell to hinder high integration.

In addition, the nonvolatile memory cell having the floating gate requires complicated manufacturing processes compared with a normal MOSFET, due to the floating gate. This increases manufacturing costs.

US-A-4 037 243 discloses a semiconductor memory cell utilizing sensing of variations in PN junction reverse current controlled by stored data. According to the subject matter of this document, a charge is stored on the gate of a gate controlled diode in a memory element to provide a junction breakdown memory cell. Such a memory cell is described in the preamble of claim 1.

DE-A-21 51 508 relates to an integrated semiconductor memory. This semiconductor memory comprises avalanche memory triodes wherein above a high impedance region of a strongly asymmetrical doped PN junction of an avalanche diode an additional control electrode is provided as a dielectric film layer. By means of charges being located at the interface of the different dielectric layers, it becomes possible to change the breakdown voltage of the PN junction near the surface between two stable values.

SUMMARY OF THE INVENTION

To solve the above-mentioned problems, an object of the present invention is to provide a novel nonvolatile memory cell that is capable of being electrically written, read and erased according to carriers captured by or released from carrier traps formed in a gate insulation film of the memory cell, and a method of manufacturing this sort of nonvolatile memory cell.

Another object of the present invention is to provide an array of nonvolatile memory cells capable of being selectively written, read and erased, occupying a small area for the sake of high integration, and being simple to manufacture.

This object is solved by a nonvolatile memory cell as described by claim 1. This nonvolatile memory cell is further developed as it is described by claims 2 to 4. Claim 5 describes a method of manufacturing a nonvolatile memory cell according to claims 1 to 4.

The present invention provides a nonvolatile memory cell comprising a semiconductor substrate of first conduction type, a high-concentration impurity region of second conduction type formed on the semiconductor substrate and connected to a bit line, an insulation film in which carrier traps are formed, and a gate electrode that is opposite the high-concentration impurity region across the insulation film and connected to a word line. Carriers are captured by and released from the carrier traps formed in the insulation film, in response to bias voltages applied to the word and bit lines. Information stored in the memory cell depends on whether or not the carrier traps are holding carriers, and the information is read

out of the memory oell as the difference of a tunneling current flowing between the semiconductor substrate and the high-concentration impurity region.

According to this arrangement, an amount of the tunneling current flowing between the semiconductor substrate and the high-concentration impurity region in an area where the gate electrode faoes the high-concentration impurity region is controlled according to the strength of a vertical electric field that changes depending on carriers captured by or released from the carrier traps formed in the area. Namely, an information storage function of the memory oell is realized by the tunneling current that drastically changes depending on whether or not the carrier traps are holding the carriers.

In the above arrangement, the amount of the tunneling current oontrolled by the magnitude of the vertical electric field is influenced by the size of a band gap of the high-concentration impurity region that is facing the gate electrode. To secure a sufficient amount of the tunneling current, it is possible to embed a material to the high-concentration impurity region to form a region that has a different band gap, and flow the tunneling current through the region.

These and other objects, features and advantages of the present invention will be more apparent from the following detailed description of preferred embodiments in conjunction with the accompanying drawings.

## BRIEF DESCRIPTION OF THE DRAWINGS

Figs. 1a and 1b are explanatory views showing an operation of a conventional EEPROM;
Fig. 2 is a view showing an arrangement of memory cells of the conventional EEPROM;
Fig. 3 is a view showing a memory cell of another conventional EEPROM;
Fig. 4 is a sectional view showing a nonvolatile memory cell according to an embodiment of the present invention;
Figs. 5a to 5d are sectional views showing manufacturing processes of the memory cell of Fig. 4;
Fig. 6 is a voltage-current characteristic diagram showing the memory cell of Fig. 4;

Fig. 7 is a sectional view showing a nonvolatile memory cell involving a material, which has a different band gap from the peripheral area, at a part where a tunneling current flows, according to another embodiment of the present invention;
Fig. 8a is a sectional view showing a nonvolatile memory cell, Figs. 8b and 8c are views showing a band structure along a line A-A' of Fig. 7;
Figs. 9a to 9c are sectional views showing manufacturing processes of the memory cell of Fig. 7;
Fig. 10a is a view showing an array of memory cells each of Fig. 4 or 8; and
Fig. 10b is a view showing four cells among the array of Fig. 10a.

## DETAILED DESCRIPTION OF THE EMBODIMENTS

Figure 4 is a sectional view showing a nonvolatile memory cell according to the embodiment of the present invention. This embodiment involves a PN junction formed on a semiconduotor substrate, and a gate electrode formed at the PN junction to realize a nonvolatile storage function.

In Fig. 4, a silicon semiconductor substrate 11 is of, for example, P type. N-type impurities such as arsenic impurities of $5 \times 10^{18}$ cm$^{-3}$ or over are implanted to the surface of the substrate 11 to form a high-concentration impurity region (a drain region) 12. The drain region 12 and substrate 11 form the PN junction.

A gate insulation film 14 such as a silicon oxide film is formed on the substrate 11. Carrier traps (hole traps) 13 of about $5 \times 10^{12}$ cm$^{-2}$ are formed in the gate insulation film 14. A gate electrode 15 of polycrystalline silicon is formed on the gate insulation film 14. The gate electrode 15 partly faces the drain region 12 across the gate insulation film 14.

An insulation film 16 is formed over the drain region 12 and gate electrode 15. Contact holes 17a and 17b are formed through the insulation film 16, and a drain wire 18 and a gate eleotrode wire 19 are connected to the drain region 12 and gate electrode 15 through the contact holes 17a and 17b, respectively.

The above arrangement forms one memory cell which is separated from adjacent memory cells by an element separation region 20.

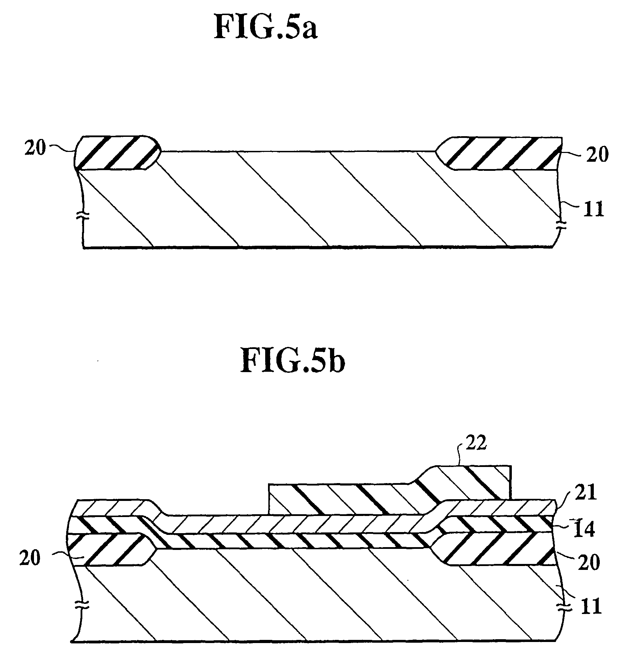

A method of manufacturing the memory cell of Fig. 4 will be explained with referenoe to Figs. 5a to 5d.

In Fig. 5a, a P-type silicon substrate 11 having impurities of, for example, $1 \times 10^{16}$ cm$^{-3}$ is selectively oxidized to form an element separation region 20 around an area where a memory cell is to be formed.

The surface of the substrate 11 is thermally oxidized at a temperature of about 900 degrees centigrade to form a gate insulation film 14, i.e., a silicon oxide film of about $2,5.10^{-8}$ m (250 angstroms) in thickness. On the gate insulation film 14, a polycrystalline silicon layer 21 is deposited to a thickness of about $3.10^{-7}$ m (3000 angstroms) by, for example, a CVD method. The layer 21 will be a gate electrode 16. Phosphorus impurities are implanted and diffused to the polycrystalline silicon layer 21 to about $1 \times 10^{20}$ cm$^{-3}$ in concentration. The layer 21 is then coated with resist. The resist is patterned to a resist pattern 22 of Fig. 5b on a part of the layer 21 where the gate electrode 16 is formed.

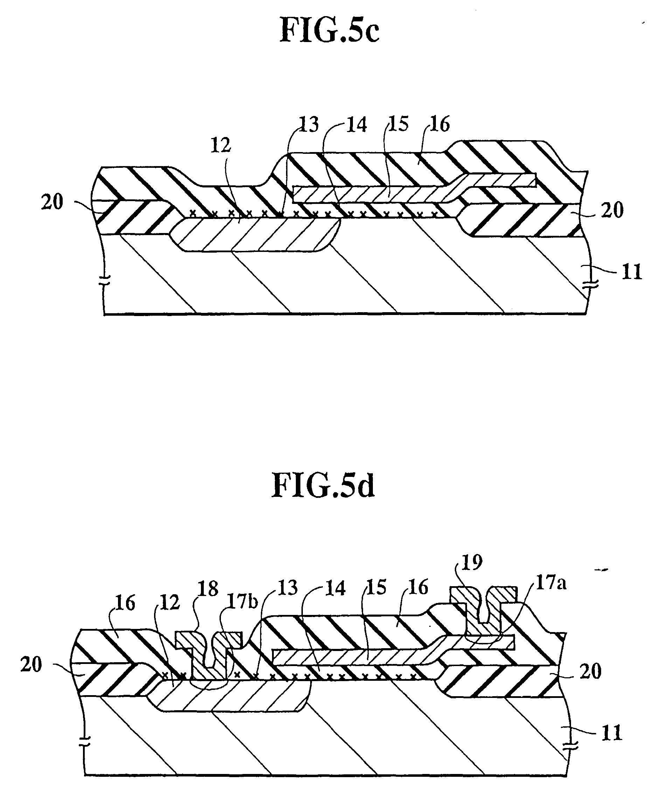

The resist pattern 22 is used as a mask, and the polycrystalline silicon layer 21 is partly etched and removed by, for example, an RIE method, thereby forming the gate electrode 15. The material is then annealed for about 60 minutes in a nitrogen atmosphere at about 1000 degrees centigrade. This forms carrier traps (hole traps) 13 of about $5 \times 10^{12}$ cm$^{-2}$ in the gate insulation film 14. Impurities such as arsenic of about $1 \times 10^{15}$ cm$^{-2}$ are ion-implanted to the substrate 11 at energy of about 160 keV, thereby forming, in a self-aligning manner, a high-concentration impurity region (a drain region) 12 on the surface of the substrate 11. Thereafter, thermal diffusion is oarried out on the material for about 30 minutes at about 900 degrees centigrade. This activates the impurities in the high-concentration impurity region 12, cures damages caused by the ion implantation, and horizontally diffuses the impurities, thereby completing the high-concentration drain region 12. A part of the drain region 12 faces the gate electrode 15 across the gate insulation film 14. An insulation film 16 is then deposited over the material by, for example, the CVD method to a thickness of about 3000 angstroms, as shown in Fig. 5c.

Contact holes 17a and 17b are opened through the insulation film 16 to reach the gate electrode 15 and drain region 12, respectively. A drain wire 18 and a gate electrode wire 19 both made of, for example, aluminum are arranged through the contact holes 17a and 17b, respectively, thereby completing the memory cell as shown in Fig. 5d. This memory cell corresponds to the one shown in Fig. 4.

An operation of the memory cell will be explained.

A current flowing between the substrate 11 and the drain region 12 changes depending on applied bias voltages. The changes in the current are related to binary information, thereby realizing a storage function of the memory cell.

The current flowing between the substrate 11 and the drain region 12 mainly passes an area where the drain region 12 faces the gate electrode 15 with the gate insulation film 14 being between them. This current is a tunneling current generated by electrons that tunnel an interface between the drain region 12 and the gate insulation film 14 from a valence band to a conduction band (inter-band tunneling). This inter-band tunneling current occurs in an overlap area of the high-concentration drain region and gate, and is described in, for example, "IEEE Electron Device Letters" Vol. EDL-8, No. 11, November 1987, pp. 515 to 517.

The tunneling current is expressed as follows with respect to a vertical electric field produced at the interface between the silicon substrate and the gate insulation film:

$$Id = A \times Ex \times \exp(-B/Es)$$

where Id is the tunneling current, A and B constants, and Es the vertical electric field at the interface between the silicon substrate and the gate insulation film. As is apparent from the above equation, the tunneling current Id drastically changes depending on changes in the vertical electric field Es. According to the present invention, the carrier traps 13 formed in the gate insulation film 14 in the area where the tunneling current occurs and where the drain region 12 faces the gate electrode 15 capture carriers, which then change the vertical electric field.

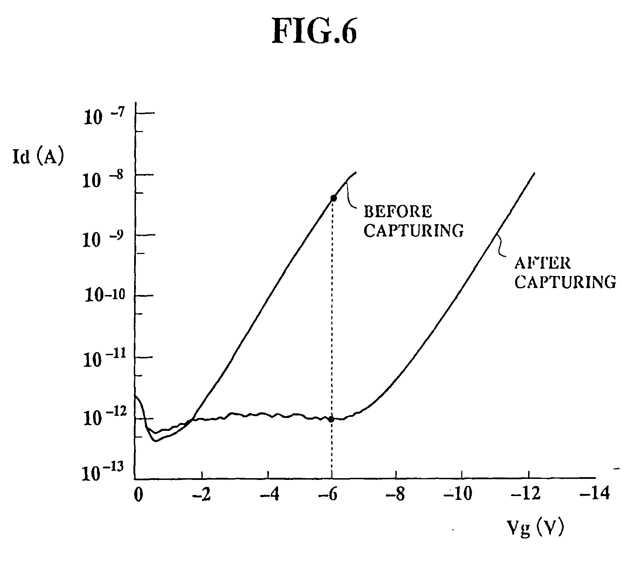

Figure 6 is a graph showing relations of an inter-band tunneling current and a gate voltage of the memory cell formed on the P-type substrate 11, before and after the carrier traps 13 capture carriers.

In Fig. 6, the number of the carrier traps is about $5 \times 10^{12}$ cm$^{-2}$. When a bias voltage of about 0 V is applied to the substrate 11 and a bias voltage of about 2 V to the drain region 12, no carrier is captured by the carrier traps. When a bias voltage of about -8 V is applied to the substrate 11 and a bias voltage of about -20 V to the gate electrode 15, carriers are captured by the carrier traps 13 in the gate insulation film 14. Measured values of the gate voltage Vg and tunneling current Id of the carrier-not-captured state and carrier-captured state are shown in Fig. 6.

In the area where the drain region 12 faces the gate electrode 15 across the gate insulation film 14, the inter-band tunneling phenomenon produces electron-hole pairs. Among the pairs, the holes run on the interface between the substrate 11 and the gate insulation film 14 and some of them surmount an energy barrier between the silicon substrate 11 and the gate insulation film (silicon oxide film) 14, because the holes receive sufficient energy from an electric field produced by the bias voltages. And the holes are captured as captured carriers by the carrier traps 13 in the film 14.

As is apparent from Fig. 6, a value of the gate voltage Vg at which the tunneling current starts to increase shifts by about 6 V before and after the carrier capturing. A value of the tunneling current Id with the gate voltage being about -6 V changes by about $10^4$ times before and after the carrier capturing.

In this way, the tunneling current drastically changes in response to the carrier capturing/releasing, i.e., the strength of the vertical electric field in the area where the tunneling current occurs. These changes of the current are related to binary information, thereby realizing the information storing function of the memory cell.

To write the memory cell, a bias voltage of about -20 V is applied to the gate electrode 15 and a bias voltage of about -8 V to the substrate 11, so that the carrier traps 13 capture carriers. At this time, if the bias voltage is applied to only one of the gate electrode 15 and substrate 11, the carrier traps 13 do not capture the carriers. This means that any memory cell can uniquely be selected to write.

To erase the memory call, the carriers captured by the carrier traps 13 are released to reestablish the carrier-not-captured state. To do so, a positive voltage of about 20 V, for example, is applied to the gate electrode 15.

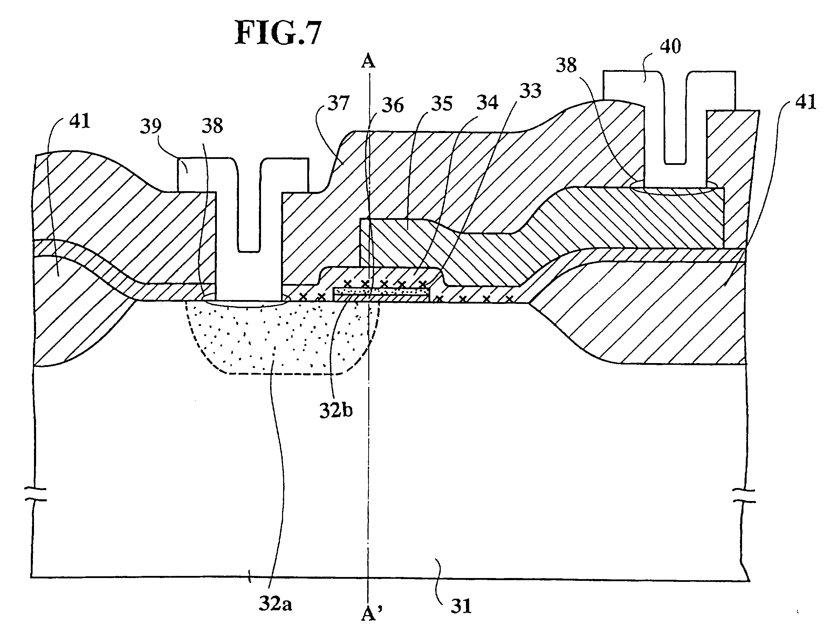

Figure 7 shows another embodiment of the present invention.

In Fig. 7, a nonvolatile memory cell comprises a high-concentration region formed in a semiconductor substrate, a PN junction formed between the high-concentration region and the substrate, and a gate electrode. To increase the tunneling current, this embodiment embeds a material to a part of the high-concentration region where the inter-band tunneling occurs to provide the part with a different band gap.

Similar to the embodiment of Fig. 4, the memory cell of Fig. 7 comprises, for example, a P-type silicon semiconductor substrate 31. N-type impurities such as phosphorus of $5 \times 10^{18}$ cm$^{-3}$ or over are implanted to the surface of the substrate 31 to form a high-concentration impurity region (a drain region) 32a. The drain region 32a and a well region 31 form a PN junction. A gate insulation film 34 made of, for example, a silicon oxide film is formed on the substrate 31. Carrier traps 33 of about $5 \times 10^{12}$ cm$^{-2}$ are formed in the gate insulation film 34. A gate electrode 35 made of, for example, aluminum is formed on the gate insulation film 34. The drain region 32a and gate electrode 35 partly face each other across the gate insulation film 34.

Material such as mixed crystals of germanium and silicon that provides a different band gap is embedded to an area 36 of the drain region 32a where the inter-band tunneling occurs. An insulation film 37 is entirely deposited. Contact holes 38 reaching the drain region 32a and gate electrode 35, respectively, are formed through the insulation film 37, and a drain wire 39 and a gate electrode wire 40 are connected to the drain region 32a and gate electrode 35, respectively, through the contact holes 38.

The above arrangement forms one memory cell, which is separated by an element separation region 41 from adjacent memory cells.

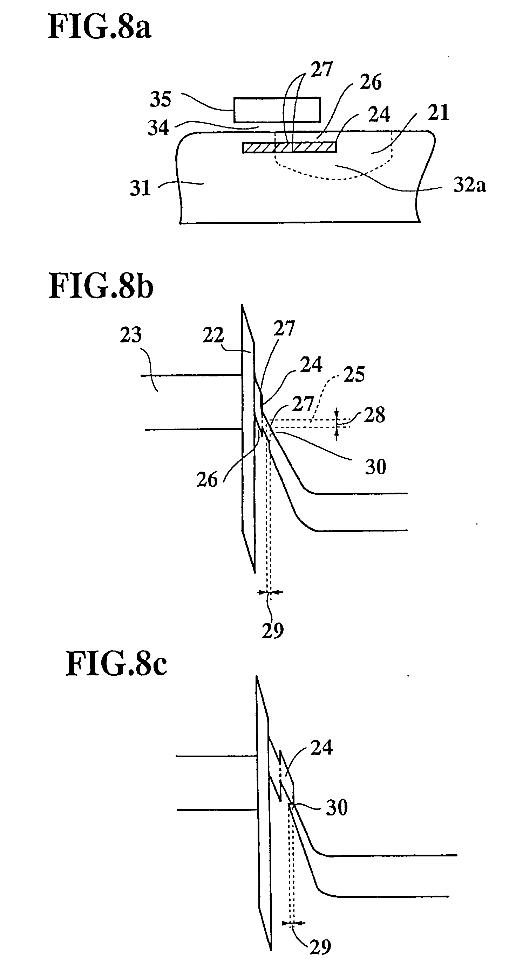

An affect of the area 36 having the different band gap in the structure of Fig. 7 on the tunneling current will be explained with reference to Figs. 8a to 8c. Figure 8a is a sectional view showing the structure of Fig. 7, and Figs. 8b and 8c show bands on a path of the tunneling current.

In an area where the drain region 32a faces the gate electrode 35 across the gate insulation film 34, the gate electrode 35 applies a strong bias to greatly bend a valence band and a conduction band, and electrons tunnel from the valence band to the conduction band. The electrons cause a tunneling current flowing between the substrate 31 and the drain region 32a. Supposing an interface level at a heterojunction is ignorable, the tunneling current can be evaluated as follows:

$$Id = A X exp(-B \quad V(x)-k^2) \qquad (1)$$

where Id is the tunneling current, A and B constants, V(x) a potential barrier against electrons in a tunnel path, x0 and x1 ends of the potential barrier, and k a constant determined by the energy of the tunneling electrons.

In the equation (1), the tunneling current Id depends on the height and width of the potential barrier against the tunneling electrons. As the band gap of semiconductor at the tunneling part becomes smaller, the height of the barrier becomes lower and the width thereof narrower. Accordingly, if the tunneling part is made of material that can reduce the integration of the exponential part of the equation (1), the inter-band tunneling current can be increased. If there is an unignorable interface level, it generates a tunneling current in addition to the one expressed by the equation (1), thereby further increasing the tunneling current. If these conditions are optimized, a sufficient tunneling current is obtainable.

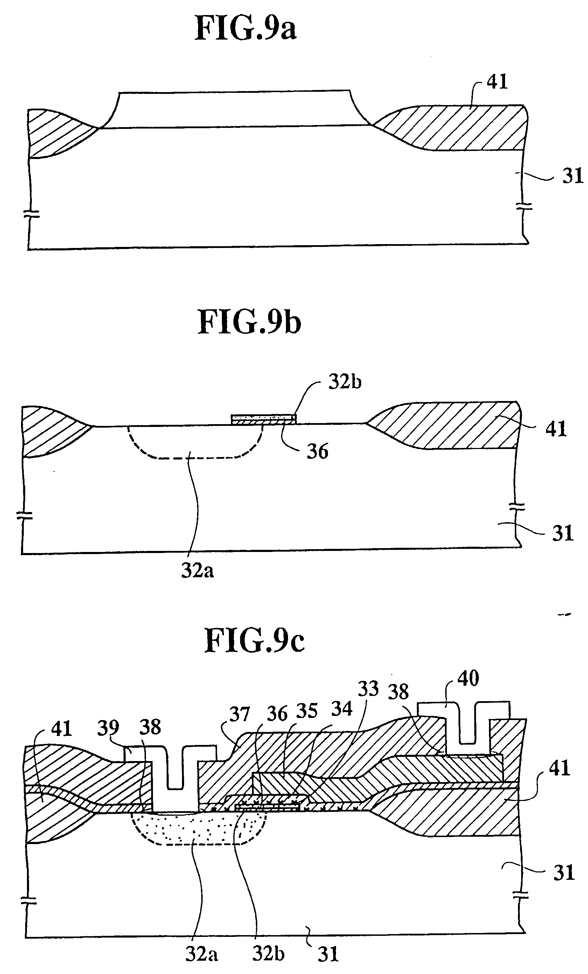

Manufacturing processes of the structure of Fig. 7 will be explained with reference to Figs. 9a to 9c.

A P-type silicon substrate with impurity concentration of about $1 \times 10^{16}$ cm$^{-3}$ is prepared. A usual selective oxidizing method is used to form an element separation region 41 made of a nitride film around a region where a memory cell is to be formed. (Fig. 9a)

The nitride film on an area where a drain region 32a is to be formed is removed. The remaining nitride film is used as a mask, and, for example, phosphorus of about $1 \times 10^{15}$ cm$^{-2}$ is ion-implanted to the substrate and thermally diffused for about 30 minutes at 900 degrees centigrade, thereby activating the implanted phosphorus. The nitride film is then removed. Hydrogen diluted $SiCl_2H_2$, $GeH_4$ and $PH_3$ are used to epitaxially grow, for example, an N-type $Si_{0.69}Ge_{0.31}$ mixed crystal layer of, for example, $5 . 10^{-9}$ m (50 angstroms) in thickness under a pressure of 6 torrs at 640 degrees centigrade. Thereafter, an N-type Si layer of, for example, $5 . 10^{-9}$ m (50 angstroms) in thickness is grown at 850 degrees centigrade. An RIE method is employed to remove the epitaxial layers so that the epitaxial layers remain partly on the drain region 32a, thereby forming the drain region 32a having an area 36 that has a different band gap. (Fig. 9b)

A plasma enhanced CVD is employed to form a gate oxide film (a gate insulation film) 34 having carrier traps 33 at 550 degrees centigrade. Aluminum, for example, is deposited by a CVD method, and etched by the RIE method to form a gate electrode 35 that partly faces the drain region 32a. An insulation film 37 is entirely deposited by, for example, the CVD method to a thickness of about $3 . 10^{-7}$ m (3000 angstroms). Contact holes 38 reaching the gate electrode 39 and drain region 32a, respectively, arc formed through the insulation film 37, and a gate electrode wire 39 and a drain wire 40 made of, for example, aluminum are formed through the contact holes 38, thereby completing the memory cell of Fig. 9c.

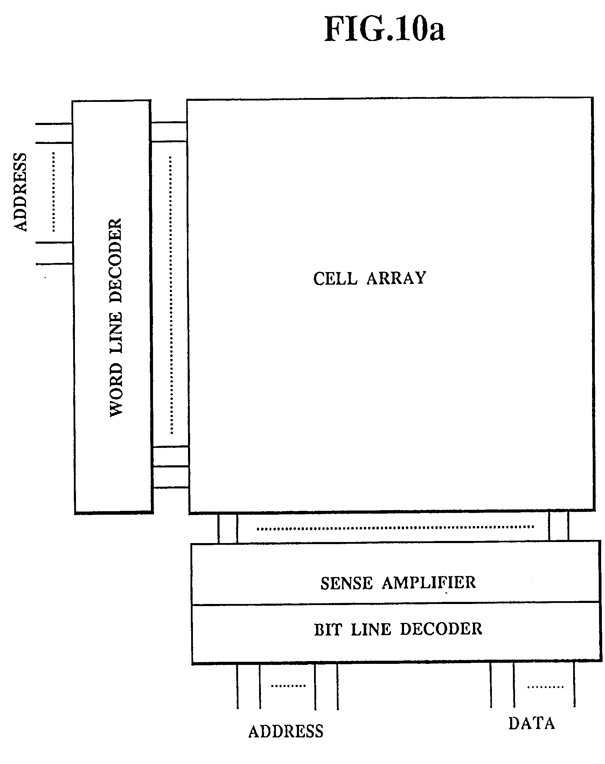

The memory cells of Fig. 4 or Fig. 7 are arranged in a matrix similar to a usual semiconductor memory, and a word line decoder, sense amplifier, bit line decoder, etc., are arranged to form a memory such as one shown in Fig. 10a.

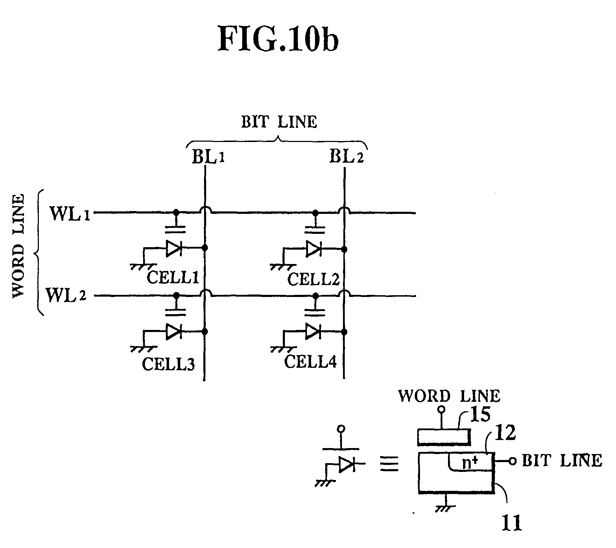

Figure 10b is a view showing four memory cells of the array of Fig. 10a.

To write a cell 1 of Fig. 10b, a bias voltage of about -20 V is applied to a word line WL1 connected to the cell 1 and a bias voltage of about +8 V to a bit line BL1 connected to the cell 1. As a result, the carrier traps 13 in the gate insulation film 14 of the cell 1 capture carriers to establish a written state.

Meantime, a bias voltage of about 0 V is applied to a word line WL2 and a bit line BL2, so that no writing or erasing voltage may be applied to other cells 2, 3 and 4. Namely, the cells 2, 3 and 4 are not written or erased, while the cell 1 is uniquely selected among the cells 1 to 4 and written.

To read the cell 1, a bias voltage of about -6 V is applied to the word line WL1 and a bias voltage of about +2 V to the bit line BL1. Since the cell 1 is holding the carriers, a tunneling current (Id) flowing between the substrate 11 and drain region 12 of the cell 1 will be about $10^{-12}$ A with respect to a gate voltage (Vg) of about -6 V, as shown in Fig. 6. This current is read through the bit line BL1. If the cell 1 is holding no carriers, the tunneling current Id will be about $5 \times 10^{-9}$ A with respect to the gate voltage Vg of about -6 V. This current is read through the bit line BL1. By detecting the difference of the current, information stored in the call 1 is known.

During the reading operation of the cell 1, a bias voltage of about 0 V is applied to the word line WL2 and bit line BL2, so that only the cell 1 is read.

To erase the cells 1 to 4, a bias voltage of about 20 V is applied to the word lines WL1 and WL2 to release carriers captured by the carrier traps 13 in the gate insulation films 14 of the cells 1 to 4.

As explained above, each memory cell according to the embodiment comprises only one high-concentration impurity region and only one gate electrode on a semiconductor substrate. This can provide a very small nonvolatile memory cell capable of being electrically written, read and erased, smaller than a usual MOSFET.

Various modifications will become possible for those skilled in the art after receiving the teachings of the present disclosure without departing from the scope thereof.

## Claims

1. A nonvolatile memory cell comprising:

    (a) a semiconductor substrate (31) of first conduction type;

    (b) a high-concentration impurity region (32a) of second conduction type formed on said semiconductor substrate of first conduction type and connected to a bit line (BL) ;

    (c) a gate insulation film (34) formed on said semiconductor substrate, in which gate insulation film carriers can be charged or discharged;

    (d) carrier traps (33) formed in said gate insulation film (34);

    (e) a gate electrode (35) formed on said gate insulation film and connected to a word line (WL), at least a part of said gate electrode being opposite said high-concentration impurity region across said gate insulation film; and

    (f) means for applying bias voltages to the word and bit lines to control carriers to be charged in and discharged from the gate insulation film between said high-concentration impurity region and said gate electrode being performed by capturing carriers by said carrier traps and releasing carriers from said carrier traps, said nonvolatile memory cell storing information therein depending on the carriers being read as the difference of a current flowing between said semiconductor substrate (31) and said high-concentration impurity region (32a),

    **characterized in**

    that said current flowing between said semiconductor substrate (31) and said high-concentration impurity region (32a) is a tunnelling current; and

    that a material is added to a part (36) of said high-concentration impurity region (32a) so that the part may have a reduced band gap, the part being located in the area where said gate electrode (35) faces said high-concentration impurity region (32a) across said gate insulation film (34) and where the interband tunnelling current occurs.

2. The nonvolatile memory cell according to claim 1, wherein an amount of the tunnelling current flowing between said semiconductor substrate (31) and said high-concentration impurity region (32a) in an area (36) where said gate electrode (35) faces said high-concentration impurity region across said gate insulation film (34) drastically changes depending on whether or not said carrier traps (33) in said gate insulation film are holding carriers.

3. The nonvolatile memory cell according to claim 1 or 2, wherein the first conduction type is P, and the second conduction type is N.

4. The nonvolatile memory cell according to any of the preceding claims, wherein said gate insulation film (34) is a silicon oxide film involving carrier traps (33) of about $5\times10^{12}$ cm$^{-2}$.

5. A method of manufacturing a nonvolatile memory cell according to any of the claims 1 to 4, comprising the steps of:

(a) preparing a semiconductor substrate (31) of said first conduction type;

(b) forming a gate insulation film (34) on the semiconductor substrate of first conduction type;

(c) forming a gate electrode (35) on the gate insulation film;

(d) annealing the semiconductor substrate with the gate insulation film and gate electrode at a predetermined temperature for a predetermined time, thereby forming carrier traps (33) in the gate insulation film;

(e) implanting and thermally diffusing impurities to the semiconductor substrate to form a high-concentration impurity region (32a) of second conduction type on the semiconductor substrate, wherein a material is added to a part (36) of said high-concentration impurity region so that the part may have a reduced band gap, which part faces the gate electrode (35) across the gate insulation film;

(f) connecting a word line (WL) to the gate electrode; and

(g) connecting a bit line (BL) to the high-concentration impurity region.

**Patentansprüche**

1. Nichtflüchtige Speicherzelle die folgendes aufweist:

(a) ein Halbleitersubstrat (31) eines ersten Leitungstyps;

(b) einen Bereich hoher Störstellendichte (32a) eines zweiten Leitungstyps, der auf dem Halbleitersubstrat des ersten Leitungstyps ausgebildet ist und an eine Bitleitung (BL) angeschlossen ist;

(c) einen Gate-Isolierfilm (34), der auf dem Halbleitersubstrat ausgebildet ist, in welchem Gate-Isolierfilm Träger geladen oder entladen werden können;

(d) Trägertraps (33), die im Gate-Isolierfilm (34) ausgebildet sind;

(e) eine Gateelektrode (35), die auf dem Gate-Isolierfilm ausgebildet ist und mit einer Wortleitung (WL) verbunden ist, wobei wenigstens ein Teil der Gateelektrode dem Bereich hoher Störstellendichte über dem Gate-Isolierfilm gegenüberliegt; und

(f) eine Einrichtung zum Anlegen von Vorspannungen an die Wort- und Bitleitungen zum Steuern, daß Träger in den Gate-Isolierfilm zwischen dem Bereich hoher Störstellendichte und der Gateelektrode geladen und aus diesem entladen werden, was durch Einfangen von Trägern durch die Trägertraps und Freigeben von Trägern aus den Trägertraps durchgeführt wird, wobei die nichtflüchtige Speicherzelle in Abhängigkeit von den Trägern Information darin speichert, die als Differenz eines Stroms gelesen werden, der zwischen dem Halbleitersubstrat (31) und dem Bereich hoher Störstellendichte (32a) fließt,

**dadurch gekennzeichnet,**

daß der Strom, der zwischen dem Halbleitersubstrat (31) und dem Bereich hoher Störstellendichte (32a) ein Tunnelstrom ist; und

daß ein Material zu einem Teil (36) des Bereichs hoher Störstellendichte (32a) hinzugefügt wird, so daß der Teil einen reduzierten Bandabstand haben kann, wobei der Teil in dem Bereich angeordnet ist, wo die Gateelektrode (35) dem Bereich hoher Störstellendichte (32a) über dem Gate-Isolierfilm (34) gegenüberliegt und wo der Tunnelstrom zwischen den Bändern auftritt.

2. Nichtflüchtige Speicherzelle nach Anspruch 1, wobei eine Menge an Tunnelstrom, der zwischen dem Halbleitersubstrat (31) und dem Bereich hoher Störstellendichte (32a) in einem Bereich (36) fließt, wo die Gateelektrode (35) dem Bereich hoher Störstellendichte über dem Gate-Isolierfilm (34) gegenüberliegt, sich in Abhängigkeit davon drastisch ändert, ob die Trägertraps (33) in dem Gate-Isolierfilm Träger halten oder nicht.

3. Nichtflüchtige Speicherzelle nach Anspruch 1 oder 2, wobei der erste Leitungstyp P ist und der zweite Leitungstyp N ist.

4. Nichtflüchtige Speicherzelle nach einem der vorangehenden Ansprüche, wobei der Gate-Isolierfilm (34) ein Siliziumoxidfilm ist, der Trägertraps (33) von etwa 5 x $10^{12}$ cm$^{-2}$ enthält.

5. Verfahren zum Herstellen einer nichtflüchtigen Speicherzelle nach einem der Ansprüche 1 bis 4, das folgende Schritte aufweist:

(a) Vorbereiten eines Halbleitersubstrats (31) des ersten Leitungstyps;

(b) Ausbilden eines Gate-Isolierfilms (34) auf dem Halbleitersubstrat des ersten Leitungstyps;

(c) Ausbilden einer Gateelektrode (35) auf dem Gate-Isolierfilm;

(d) Aushärten des Halbleitersubstrats mit dem Gate-Isolierfilm und der Gateelektrode bei einer vorbestimmten Temperatur für eine vorbestimmte Zeit, um dadurch Trägertraps (33) im Gate-Isolierfilm auszubilden;

(e) Implantieren und thermisches Diffundieren von Störstellen in das Halbleitersubstrat, um einen Bereich hoher Störstellendichte (32a) des zweiten Leitungstyps auf dem Halbleitersubstrat auszubilden, wobei ein Material zu einem Teil (36) des Bereichs hoher Störstellendichte hinzugefügt wird, so daß der Teil einen reduzierten Bandabstand haben kann, welcher Teil der Gateelektrode (35) über dem Gate-Isolierfilm gegenüberliegt;

(f) Verbinden einer Wortleitung (WL) mit der Gateelektrode; und

(g) Verbinden einer Bitleitung (BL) mit dem Bereich hoher Störstellendichte.

**Revendications**

1. Cellule mémoire rémanente comprenant :

(a) un substrat semi-conducteur (31) d'un premier type de conduction ;
(b) une région d'impuretés à concentration élevée (32a) d'un second type de conduction formée sur ledit substrat semi-conducteur du premier type de conduction et connectée à une ligne de bits (BL) ;
(c) un film isolant de grille (34) formé sur ledit substrat semi-conducteur dans lequel film isolant de grille, des porteurs de charge peuvent être accumulés ou évacués ;
(d) des pièges à porteurs de charge (33) formés dans ledit film isolant de grille (34) ;
(e) une électrode de grille (35) formée sur ledit film isolant de grille et connectée à une ligne de mots (WL), au moins une partie de ladite électrode de grille étant opposée à ladite région d'impuretés à concentration élevée à travers ledit film isolant de grille ; et
(f) un moyen pour appliquer des tensions de polarisation aux lignes de mots et de bits afin de commander l'accumulation et l'évacuation des porteurs de charge à partir du film isolant de grille entre ladite région d'impuretés à concentration élevée et ladite électrode de grille étant réalisé par la capture des porteurs de charge par lesdits pièges à porteurs de charge et la libération des porteurs de charge à partir desdits pièges à porteurs de charge, ladite cellule mémoire rémanente stockant des informations dans celle-ci en fonction du fait que les porteurs de charge sont lus comme la différence d'un courant circulant entre ledit substrat semi-conducteur (31) et ladite région d'impuretés à concentration élevée (32a),
caractérisé en ce que
ledit courant circulant entre ledit substrat semi-conducteur (31) et ladite région d'impuretés à concentration élevée (32a) est un courant à effet tunnel et
qu'un matériau est ajouté à une partie (36) de ladite région d'impuretés à concentration élevée (32a) d'une manière telle que la partie peut présenter une largeur de bande interdite réduite, la partie étant placée dans la zone où ladite électrode de grille (35) est en regard de ladite région d'impuretés à concentration élevée (32a) à travers ledit film isolant de grille (34) et où le courant à effet tunnel interbande se produit.

2. Cellule mémoire rémanente selon la revendication 1, dans laquelle l'intensité du courant à effet tunnel circulant entre ledit substrat semi-conducteur (31) et ladite région d'impuretés à concentration élevée (32a) dans une zone (36) où ladite électrode de grille (35) est en regard de ladite région d'impuretés à concentration élevée à travers ledit film isolant de grille (34) change grandement en fonction du fait que les pièges à porteurs de charge (33) dans ledit film isolant de grille contiennent des porteurs de charge.

3. Cellule mémoire rémanente selon la revendication 1 ou 2, dans laquelle le premier type de conduction est P et le second type de conduction est N.

**4.** Cellule mémoire rémanente selon l'une quelconque des revendications précédentes, dans laquelle ledit film isolant de grille (34) est un film d'oxyde de silicium comprenant des pièges à porteurs de charge (33) en un nombre d'environ $5 \times 10^{12}$ cm$^{-2}$.

**5.** Procédé de fabrication d'une cellule mémoire rémanente selon l'une quelconque des revendications 1 à 4, comprenant les étapes consistant à :

(a) préparer un substrat semi-conducteur (31) d'un premier type de conduction ;
(b) former un film isolant de grille (34) sur le substrat semi-conducteur du premier type de conduction ;
(c) former une électrode de grille (35). sur le film isolant de grille ;
(d) recuire le substrat semi-conducteur avec le film isolant de grille et l'électrode de grille à une température prédéterminée pendant un temps prédéterminé, formant de ce fait des pièges à porteurs de charge (33) dans le film isolant de grille ;
(e) implanter et diffuser thermiquement des impuretés dans le substrat semi-conducteur afin de former une région d'impuretés à concentration élevée (32a) d'un second type de conduction sur le substrat semi-conducteur, dans lequel un matériau est ajouté à une partie (36) de ladite région d'impuretés à concentration élevée d'une manière telle que la partie peut présenter une largeur de bande interdite réduite, laquelle partie est en regard de l'électrode de grille (35) à travers le film isolant de grille ;
(f) connecter une ligne de mots (WL) à l'électrode de grille ; et
(g) connecter une ligne de bits (BL) à la région d'impuretés à concentration élevée.

# FIG.1a

ERASE

# FIG.1b

WRITE

# FIG.2

# FIG.3

WORD LINE

BIT LINE

6

5

# FIG.4

## FIG.5a

## FIG.5b

# FIG.5c

# FIG.5d

# FIG.6

# FIG.7

EP 0 420 182 B1

# FIG.8a

# FIG.8b

# FIG.8c

# FIG.9a

# FIG.9b

# FIG.9c

# FIG.10a

# FIG.10b